# EUROPÄISCHE PATENTSCHRIFT

(11) **EP 2 336 799 B1**
(45) Veröffentlichungstag und Bekanntmachung des Hinweises auf die Patenterteilung: **12.02.2014**
(21) Anmeldenummer: 10193795.1
(22) Anmeldetag: 06.12.2010
(51) Int. Cl.: G01R 33/36

(54) **Verfahren zur Regelung von HF-Signalen in einem NMR-System sowie NMR-System zur Durchführung des Verfahrens**
Method for regulating HF signals in an NMR system and NMR system for performing the method
Procédé de réglage de signaux HF dans un système RMN et système RMN pour l'exécution du procédé

(30) Priorität: 07.12.2009 DE 102009047565
(43) Veröffentlichungstag der Anmeldung: 22.06.2011
(73) Patentinhaber: Bruker BioSpin AG, 8117 Fällanden (CH)
(72) Erfinder: Freytag, Nicolas, 8122 Binz (CH)
(74) Vertreter: Kohler Schmid Möbus

(56) Entgegenhaltungen:
- EP-A1- 0 489 312
- JP-A- 61 118 649
- US-A- 4 739 268
- RETOURNARD A ET AL: "A VERSATILE SECONDARY TRANSMITTER UNIT FOR NUCLEAR MAGNETIC RESONANCE SPECTROSCOPY", REVIEW OF SCIENTIFIC INSTRUMENTS, AIP, MELVILLE, NY, US, Bd. 61, Nr. 1, PART 01, 1. Januar 1990 (1990-01-01), Seiten 69-76, XP000101213, ISSN: 0034-6748, DOI: DOI:10.1063/1.1141902

## Beschreibung

### Hintergrund der Erfindung

Die Erfindung betrifft ein Verfahren zur Regelung von Hochfrequenz (HF)-Signalen in einem Kernspinmagnetresonanz (NMR) System umfassend ein Spektrometer, einen Regelkreis und einen NMR-Probenkopf, wobei das Spektrometer einen Sender umfasst, der HF-Signale auf Messfrequenzen mit einer Sendeleistung sendet, der NMR-Probenkopf mindestens einen HF-Schwingkreis enthält, der mittels erster HF-Bauteile auf die Resonanzfrequenz einer zu untersuchenden Kemart abgestimmt ist, wobei der HF-Schwingkreis mindestens eine HF-Spule umfasst, die um eine Messprobe angeordnet ist und durch Aussenden der HF-Signale zum Anregen von Kemspins in einer Probe und zum Empfangen von aus dieser Anregung resultierenden NMR-Signalen dient, und wobei der NMR-Probenkopf weitere HF-Bauteile enthalten kann, die Bestandteile des HF-Schwingkreises, von Koppel- sowie von Filternetzwerken sein können, wobei mit Hilfe des NMR-Probenkopfs eine Messung eines Parameters durchgeführt wird, über den der Strom in oder die Spannung über der HF-Spule oder einem der ersten HF-Bauteile oder gegebenenfalls einem der weiteren HF-Bauteile bestimmt werden kann, und wobei der Regelkreis die Sendeleistung in Abhängigkeit des gemessenen Parameters regelt und begrenzt.

Ein gattungsgemäßes Verfahren ist aus der JP-A-61 118 649 bekannt.

Bei NMR Spektrometersystemen werden hochfrequente Pulse mittels einer Sende- oder Sende-/Empfangsspule auf eine Messprobe eingestrahlt und die zeitaufgelöste Antwort aus der Messprobe detektiert. Dabei koppelt der magnetische Feldanteil der HF-Felder ("magnetisches Feld") mit dem Spinsystem. Häufig werden auch mehrere Messfrequenzen mittels eines Abstimmungsnetzwerkes auf einer einzigen Sende-/Empfangsspule verschaltet. Neben Ein- und Mehrwindungsspulen, die als Sattelspulen oder als Solenoidspulen ausgeführt sein können, finden auch Resonatorstrukturen wie Birdcage oder Alderman-Grant Resonatoren Verwendung. Seltener werden andere Typen von Resonatoren eingesetzt, wie z.B. Koaxial- oder Transmission-Line-Resonatoren. Im Folgenden soll unter "Spule" jegliche Form von Sende- oder Sende-/Empfangsstruktur verstanden werden, die dazu dient, in einer Messprobe ein HF-Feld zu erzeugen.

Die Anregungspulse haben bei definiertem magnetischem Feld, d.h. bei definierter Amplitude des Stromes in der Spule, und definierter Sendefrequenz f₀ eine charakteristische Zeitdauer (Pulsdauer p₁), um die Kernspinmagnetisierung einer bestimmten Spezies von Kernen mit Resonanzfrequenz f_{S} = f₀ um 90° zu drehen.

Die zu weiteren Pulswinkeln zugehörigen Pulsdauern können in der Regel aus dieser 90°-Pulsdauer einfach berechnet werden. Unterscheidet sich die Sendefrequenz f₀ der HF-Pulse und die Resonanzfrequenz f_{S} der Spins fällt der Pulswinkel bei identischer Amplitude des Stromes von 90° verschieden aus. Die Anregungsbreite eines HF-Pulses ist in der Regel umgekehrt proportional zu dessen Pulsdauer.

Zur Erzeugung des hochfrequenten Magnetfeldes in der Messprobe muss ein Strompuls in der Spule erzeugt werden. Die Spule wird in der Regel mittels Kondensatoren und/oder einem Abstimmnetzwerk zu einem Schwingkreis verschaltet und auf die Resonanzfrequenz der Kemspins abgestimmt. Dieser Schwingkreis wird mittels eines Kopplungsnetzwerkes über Transmissionsleitungen mit definierter Impedanz (normalerweise 50 Ω) an einen Sender angeschlossen. Das Kopplungsnetzwerk dient dazu, die Impedanz des Schwingkreises an die Impedanz der Transmissionsleitung anzupassen. Bei optimaler Anpassung wird eine Welle ohne Reflexionen übertragen. Bei Fehlanpassung wird ein Teil der Welle am Kopplungsnetzwerk reflektiert. Derartige Reflexionen finden an allen Impedanzbrüchen statt. Daher ist es wichtig, die Schwingkreise für die verschiedenen Messfrequenzen eines Messkopfes abzustimmen und die Impedanzen an die Transmissionsleitungen anzupassen. Bei perfekter Anpassung wird im stationären Grenzfall die gesamte gesendete Leistung in den Schwingkreis übertragen und dort dissipiert.

Die Impedanz eines Schwingkreises bei Resonanz ist (bei fester Induktivität der Spule) umgekehrt proportional zu seiner Güte. Bei der Verwendung von verlustbehafteten Messproben sinkt jedoch die Güte eines NMR Detektionssystems durch die zusätzlichen Verluste in der Messprobe. Daher ist eine Anpassung der Impedanztransformation notwendig. Diese Anpassung wird als "Matching" bezeichnet. Des Weiteren ändert sich aufgrund der die Messprobe durchdringenden elektrischen Feldkomponenten die Resonanzfrequenz eines Schwingkreises. Diese muss beim Wechsel einer Messprobe wieder an die Sendefrequenz angepasst werden um Reflexionen zu vermeiden und die optimale Empfindlichkeit beim Empfang sicherzustellen. Dieser Vorgang wird als "Tuning" bezeichnet.

Durch die Erhöhung des Verlustwiderstandes/Emiedrigung der Güte beim Einführen einer verlustbehafteten Messprobe in den Messkopf wird bei gleicher übertragener Leistung allerdings weniger Strom im Schwingkreis auftreten; das erzeugte hochfrequente Magnetfeld hat eine geringere Amplitude und um denselben Flipwinkel der Kemspins erreichen zu können, muss entweder die Dauer der Pulse verlängert oder die Sendeleistung erhöht werden.

Bei NMR Spektrometern gemäß Stand der Technik wird die Pulsdauer angepasst, um die zusätzlichen Verluste zu kompensieren. Diese Verlängerung der Anregungspulse führt zu einer Verringerung der Anregungsbandbreite bei Verwendung verlustbehafteter Messproben im Vergleich zu verlustfreien Messproben.

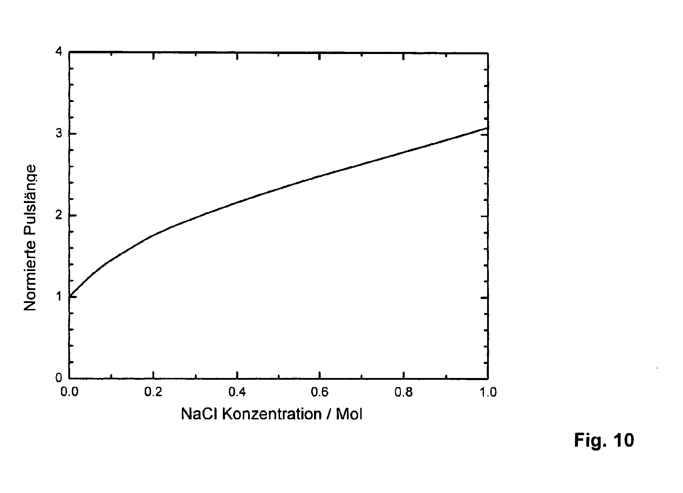

Der Grund für die Verlängerung der Pulsdauem ist, dass um den Messkopf vor Zerstörung z.B. durch Spannungsdurchschläge zu schützen, in der Regel die gesendete Leistung begrenzt wird. Damit erreicht der Messkopf die kürzeste Pulsdauer pₘᵢₙ für einen 90° Puls nur mit verlustlosen Messproben, hat aber mit verlustbehafteten zum Teil deutlich längere Pulsdauer p₁ > pₘᵢₙ. Fig. 10 veranschaulicht die Verlängerung der Pulsdauer (p₁/pₘᵢₙ) als Funktion der Salzkonzentration in der Probe für einen typischen NMR Messkopf.

Die Verlängerung der Pulsdauer führt zu einer linearen Reduktion der Spektralbreite bei der Anregung. Je länger die Pulse sind, desto schlechter wird in der Regel die spektroskopische Qualität. Spektralbereiche, die weit von der Anregungsfrequenz entfernt sind, werden nicht oder nur unzureichend angeregt, so dass die Signalintensitäten dort verringert sind bzw. überhaupt kein Signal mehr empfangen wird. Es ist durchaus üblich, dass über den relevanten Bereich an Lösungsmittelverlusten sich die Pulsdauer verdoppeln oder sogar verdreifachen kann. Dies bedeutet allerdings auch, dass lediglich die halbe oder sogar nur ein Drittel der spektralen Breite der Anregung zur Verfügung steht. Dies ist insbesondere für Inversionspulse extrem kritisch, da diese bereits eine deutlich geringere Anregungsbreite als ein 90° Puls besitzen. Häufig kann mit verlustbehafteten Messproben keine ausreichende Anregung mit Inversionspulsen mehr erreicht werden, so dass auf so genannte adiabatische Pulse ausgewichen werden muss. Diese benötigen jedoch eine deutlich höhere dissipierte Gesamtleistung und haben eine massiv längere Gesamtdauer, während derer das Spinsystem evoluiert und können nicht in jeder Situation eingesetzt werden. Aus diesen Gründen ist es oft wünschenswert, auf solche Pulse zu verzichten.

Weiterhin besteht das Problem, dass Leistungsverstärker in der Regel nicht auf 50 Ω angepasst, sondern niederohmiger sind, um deren Wirkungsgrad zu erhöhen. Bei einer Fehlanpassung des Messkopfes und bestimmter Kabellängen zwischen Verstärker und Sendespule kann die effektiv gelieferte Leistung höher sein als bei einer Anpassung auf 50 Ω. Dadurch wird Spannung/Strom in der Spule bzw. dem Netzwerk höher, obwohl die nominell gesendete Leistung identisch ist. Aufgrund dieser Tatsache muss die Sendeleistung auf einen Wert begrenzt werden, der ausreichend Reserve beinhaltet, um auch den Fall der Fehlanpassung abzudecken.

Für kurze Sendepulse ist bei hohen Resonatorgüten die Anpassung an 50 Ω nicht die ideale Leistungsanpassung. Bedingt durch die hohe Resonatorgüte findet ein Einschwingvorgang statt, währenddessen die ideale Leistungsanpassung massiv von der des stationären Zustandes abweicht. Bei hohen (Q > 1000) bzw. sehr hohen (Q > 10000) Güten und kurzen Pulsen (p1 < 10 µs) wird der stationäre Zustand über die Pulsdauer nicht erreicht, so dass die kürzesten Pulswinkel nicht mit 50 Ω Anpassung erreicht werden.

In der Praxis treten auch Situationen auf, in denen aus einem bekannten Puls mit Flipwinkel α₁, Pulsdauer p₁ und Leistung P₁ ein Puls mit Flipwinkel α₂, Pulsdauer p₂ und Leistung P₂ nur fehlerhaft berechnet werden kann. Gründe hierfür sind z.B. Nichtlinearitäten der verwendeten Spulenmaterialien über den Leistungsbereich P₁ bis P₂, die neben erhöhter Dissipation auch zur Fehlanpassung und damit erhöhter Reflexion führen. Solche Nichtlinearitäten können z.B. durch Erwärmung oder bei supraleitenden Spulenmaterialien, die nahe ihrer kritischen Ströme betrieben werden, auftreten. Bei sehr hohen Güten oder hoher Sendeleistung kann sogar die Situation auftreten, dass bei konstanter Sendeleistung ein Puls mit großem Flipwinkel nicht korrekt aus einem Puls mit kleinem Flipwinkel berechnet werden kann. Im ersten Fall ist der Grund die Reflexion des gesendeten Signals am Resonator durch Fehlanpassung während des Einschwingvorgangs, wie im vorhergehenden Abschnitt dargelegt. Im zweiten Fall ist die durch die Dissipation der hohen Leistung erfolgte Erwärmung über die Dauer eines Pulses verantwortlich.

### Aufgabe der Erfindung

Es ist daher Aufgabe der Erfindung, ein Verfahren, einen ,NMR-Probenkopf und ein NMR-System vorzuschlagen, mit denen auftretenden Verluste kompensiert werden können, insbesondere ohne die Pulsdauer zu verkürzen, Fehler in der Berechnung von Pulsen zu korrigieren oder die Bestimmung von Pulsen zu automatisieren.

### Kurze Beschreibung der Erfindung

Diese Aufgabe wird erfindungsgemäß durch ein Verfahren gemäß Patentanspruch 1, sowie einem NMR-System gemäß Patentanspruch 10 gelöst.

Im Rahmen der hier vorgestellten Erfindung wurde erkannt, dass sich die Begrenzung der Sendeleistung ohne das Hinzunehmen weiterer Parameter nicht eignet, um einen Messkopf effizient vor Zerstörung zu schützen. In der Regel führt eine zu hohe Spannung zu elektrischen Durchschlägen. Andernfalls, z.B. bei supraleitenden Resonatorsystemen oder bei Microcoils, d.h. Spulen deren Größe im Bereich von unter einem bis zu 1000 Mikrometern liegen, führt ein zu hoher Strom zu starker Dissipation oder Quenchen und damit zur Zerstörung der Spulen.

Die gesendete Leistung ist eine Größe, die von vielen Parametern abhängig ist und nicht direkt für die Zerstörung verantwortlich ist. Da die Leistung am kritischen Bauteil von mehr Parametern als lediglich der Güte und Effizienz der Sendespule oder des Netzwerkes abhängt, z.B. von der korrekten Anpassung, den zusätzlichen Verlusten durch die Messprobe etc., wird bei dem erfindungsgemäße Verfahren, die kritische Größe (Strom im bzw. oder Spannung über dem kritischen Bauteil) begrenzt.

Im Gegensatz zum Stand der Technik, bei dem ein Regelkreis prüft, ob die Leistung kleiner ist als eine bestimmte Maximalleistung und anhand dieser Information das Senden einer zu großen Leistung verhindert, sieht das erfindungsgemäße Verfahren vor; einen Parameter zu messen, der eine Aussage über den Strom in bzw. die Spannung über einem kritischen Bauteil zulässt. Dieser gemessenen Parameter ist dann ausschlaggebend für die nachfolgende Regelung.

Hierdurch kann die Sendeleistung derart angepasst werden, dass dieselbe minimale Pulsdauer pₘᵢₙ mit jeder Messprobe und bei jeder Abstimmung realisiert werden kann.

Weiterhin wurde erkannt, dass ein erfindungsgemäßer Regelkreis, der die Dauer und/oder die Phase und/oder die Leistung der gesendeten HF-Signale in Abhängigkeit eines gemessenen Parameters regelt, der eine direkte Abhängigkeit vom Strom oder der Spannung über einem der HF-Bauteile hat, dazu eingesetzt werden kann Fehler in der Berechnung von Pulsen zu korrigieren, und/oder Pulse automatisiert zu bestimmen, insbesondere ohne Messung eines NMR-Signals zu bestimmen.

Erfindungsgemäß begrenzt der Regelkreis die Sendeleistung, wobei maximal erlaubte Strom- und/oder Spannungswerte in/über der HF-Spule oder einem der ersten HF-Bauteilen oder gegebenenfalls einem der weiteren HF-Bauteile festgelegt werden, die gerade noch nicht zur Zerstörung der HF-Spule bzw. des ersten HF-Bauteiles bzw. des weiteren HF-Bauteils führen, wobei der Regelkreis die Sendeleistung so lange erhöht, bis die maximal erlaubte Strom- und/oder Spannungswerte gerade nicht überschritten werden.

Bei einer ersten Variante des erfindungsgemäßen Verfahrens kann als Parameter die Güte des HF-Schwingkreises und/oder die Impedanzanpassung des HF-Schwingkreises an eine Transmissionsleitung gemessen werden. Werden die Güte und die Anpassung der Frequenz und der Impedanz des HF-Schwingkreises bestimmt, kann bereits vor dem Senden des ersten Pulses die zu einer vorgegebenen Pulsdauer p₁ und vorgegebenem Flipwinkel α₁ zugehörige Sendeleistung P₁ berechnet werden.

Dabei wird vorzugsweise zur Messung der lmpedanzanpassung des HF-Schwingkreises die an der Transmissionsleitung reflektierte Leistung gemessen, und die Sendeleistung des HF-Signals so eingestellt, dass Pₛ = Pₛₒₗₗ (Q) + P_{R}, wobei Pₛₒₗₗ (Q) diejenige Leistung ist, die im Messkopf dissipiert werden muss, um einen Soll-Pulswinkel αₛₒₗₗ bei gegebener Pulsdauer p₁ des HF-Signals zu realisieren. P_{R} ist die reflektierte Leistung und Pₛ die Sendeleistung des HF-Signals.

Eine zweite Variante des erfindungsgemäßen Verfahrens sieht vor, dass als Parameter die Pulsdauer eines HF-Pulses mit gewünschtem Pulswinkel gemessen wird.

Vorzugsweise wird die Pulsdauer durch Detektion mindestens eines NMR-Signals mittels des NMR-Spektrometers ermittelt. Dabei kann zum Beispiel ein Nutationsexperiment mit einer Leistung Pₛ < Pₘₐₓ durchgeführt werden.

Diese Variante kann durchgeführt werden, indem ein Startwert, vorzugsweise die Maximalleistung der Sendespule, für die Sendeleistung gewählt wird, das NMR-Signal mittels des NMR-Spektrometers aufgenommen wird, wobei ein HF-Puls mit dem Startwert der Sendeleistung eingestrahlt wird; mittels des aufgenommenen NMR-Signals der Pulswinkel des zur Erzeugung des NMR-Signals eingestrahlten HF-Pulses ermittelt wird, und durch diesen ermittelten Pulswinkel die Sendeleistung des HF-Pulses mit gewünschtem Pulswinkel und gewünschter Pulsdauer bestimmt wird. Unter "Maximalleistung der Sendespule" versteht man die Leistung, die gerade noch von der Sendespule umgesetzt werden kann, ohne die Spule zu zerstören. In Bezug auf den Stand der Technik erlaubt diese Variante das Einstrahlen von Leistungen, die höher sein können als ein vorgegebener Grenzwert der Sendeleistung, falls durch Fehlanpassung und/oder zusätzliche Dissipation der Strom in der Sendespule niedriger ausfällt als unter "idealen" Vorraussetzungen.

Eine dritte Variante des erfindungsgemäßen Verfahrens sieht vor, dass als Parameter das von der HF-Spule erzeugte hochfrequente H- oder E-Feld gemessen wird. Die Bestimmung des hochfrequenten Magnetfelds ermöglicht eine genaue Bestimmung des Pulses. Bei diesem Verfahren muss zunächst durch eine Kalibrationsmessung die Abhängigkeit eines zu messenden Parameters von Amplitude und/oder Phase des hochfrequenten elektromagnetischen Feld bestimmt werden. In der Folge kann jeder beliebige Puls (mit vorgegebener Phase, Frequenz, Flipwinkel sowie Pulsdauer) mittels des Regelkreises (durch Messung und Abgleichen dieses Parameters) eingestellt werden. Abgeglichen werden können sowohl die Feldstärke als auch die Phase des HF-Feldes in der Messprobe, indem Phase und Sendeleistung modifiziert werden.

Dabei ist es vorteilhaft, wenn das von der HF-Spule erzeugte hochfrequente H-oder E-Feld mittels einer Messsonde gemessen wird, die an eines der HF-Bauteile des Abstimmungsnetzwerkes oder direkt an die Sendespule, gekoppelt ist. Neben dem Vorzug der Zeiteinsparung durch die automatisierten Regelung des Pulswinkels vor einem NMR-Experiment, ist insbesondere auch die Möglichkeit der Pulsbestimmung für extrem verdünnte Messproben relevant: Mittels einer Sonde kann der Pulswinkel auch dann genau gemessen werden, wenn für eine bestimmte Messprobe ein sehr geringes Signal/Rausch-Verhältnis die Messung eines aussagekräftigen NMR-Spektrums mit sinnvollem Zeitaufwand nicht ermöglicht. Dies ist in der Regel für Entkopplungskerne wie 13C oder 15N der Fall, wenn diese in der Messprobe in natürlicher Häufigkeit vorliegen und für eine Bestimmung des Pulswinkels die Integration hunderter oder tausender Scans benötigen würden. Im Stand der Technik wird in einer solchen Situation kein Puls bestimmt, sondern es wird der Puls einer Vergleichsmessung unter Verwendung einer anderen (mit diesen Isotopen angereicherten) Messprobe verwendet.

Bei der dritten Variante des erfindungsgemäßen Verfahrens besteht die Möglichkeit, dass die Sendeleistungen und/oder die Phasen der HF-Signale über die Dauer einer Pulsfolge angepasst werden, wobei während der Pulsfolge mehrere Messungen des von der HF-Spule erzeugten hochfrequenten H- oder E-Feldes durchgeführt werden. Bei dieser Verfahrensvariante werden für verschiedene Pulse einer Pulsfolge verschiedene Werte ermittelt. Somit können Artefakte aufgrund von Heizeffekten des Netzwerkes, Nichtlinearitäten der HF-Spulen oder HF-Bauteile und Kumulationseffekte die auftreten wenn die Abklingzeiten länger sind als die Zeiten zwischen dem Senden zweier Pulse auf derselben Frequenz oder beim simultanen Senden von Pulsen mit unterschiedlichen Frequenzen, korrigiert werden.

Alternativ hierzu kann es auch vorteilhaft sein, wenn die Sendeleistungen und/oder die Phasen der HF-Signale über die Dauer eines einzelnen Pulses angepasst wird, wobei das von der HF-Spule erzeugte hochfrequente H- oder E-Feld in Abhängigkeit von der Zeit gemessen wird. Bei dieser Variante wird die Ein-und Ausschwingzeit der HF-Spule samt Sender, Leistungsverstärker und eventuell im Sendepfad vorhandener Filter berücksichtigt. Dies ist insbesondere bei HF-Spulen mit hoher Güte vorteilhaft, bei denen die Zeitkonstante in der gleichen Größenordnung liegt wie die Pulslänge. Zu Beginn des Einschwingvorgangs wird der größte Teil der Sendeleistung reflektiert. Die Leistung wird erst im Laufe des Einschwingens vollständig im System, bestehend aus Resonator und Messprobe, aufgenommen und dissipiert. Aus diesem Grunde kann zu Beginn eines Pulses eine Sendeleistung deutlich über Pₘₐₓ verwendet werden, ohne die Leistungsgrenzen der HF-Spule zu erreichen, wohingegen gegen Ende des Pulses die Leistung auf die Maximalleistung zurückgefahren werden muss. Das erfindungsgemäße Verfahren sieht daher vor, einen dynamischen Wert während eines Pulses (H- oder E-Feld als Funktion der Zeit über die Dauer eines Pulses) zu messen und ermöglicht somit eine risikolose Verwendung von Sendeleistungen grösser als der Maximalleistung Pₘₐₓ.

Besonders vorteilhaft ist es, wenn die Regelung der Sendeleistung über die Dauer eines Pulses so ausgeführt wird, dass die damit erzeugte HF-Pulsform weitestgehend mit einer vorher festgelegten Pulsform übereinstimmt. Der Fehler des Flipwinkels für das angeregte Spinsystem sollte dabei geringer als 20°, vorzugsweise weniger als 10° in Bezug auf den theoretischen Wert betragen. Eine besonders bevorzugte Variante des erfindungsgemäßen Verfahrens sieht vor, dass die Bestimmung der HF-Pulse ohne Messung eines NMR-Signals aus der Messprobe erfolgt. D.h. es wird eine Pulsfolge eingestrahlt und das dabei entstehende H-Feld und/oder E-Feld gemessen, ohne eine Antwort des Systems abzuwarten. Dies ist besonders vorteilhaft, da die Anforderungen an die Messung eines aussagekräftigen NMR-Signals sehr hoch sind. Weiterhin können so exakt definierte Pulswinkel bzw. komplexe Spinoperationen präzise eingestellt werden.

In der Regel werden vor der Aufnahme eines NMR-Spektrums sogenannte "Dummyscans" durchgeführt. Während dieser wird die volle Pulssequenz auf die Messprobe eingestrahlt aber kein Signal gemessen. Die Dummyscans dienen dazu das System ins Gleichgewicht zu bringen (einerseits thermisch, andererseits soll auch das Spinsystem eine neue Gleichgewichtsmagnetisierung einnehmen, die sich von derjenigen des ungestörten Systems in der Regel unterscheidet) Bei dieser besonders bevorzugten Ausführungsform der Erfindung kann die Feinabstimmung der Pulse während der "Dummyscans" erfolgen, so dass diese ohne Zeitverlust für die Messung erfolgen kann.

Die Erfindung betrifft auch ein Kernspinmagnetresonanz(NMR)-System gemäß Anspruch 10.

Weitere Vorteile der Erfindung ergeben sich aus der Beschreibung und der Zeichnung. Ebenso können die vorstehend genannten und die weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Zeichnung und detaillierte Beschreibung der Erfindung

Es zeigen:
- Fig. 1: einen Regelkreis gemäß Variante 1 des erfindungsgemäßen Verfahrens, bei dem die Sendeleistung in Abhängigkeit von der gemessenen Güte geregelt wird;
- Fig. 2: einen Regelkreis gemäß Variante 2 des erfindungsgemäßen Verfahrens, bei dem die Sendeleistung in Abhängigkeit von der gemessenen Pulsdauer eines HF-Pulses geregelt wird;
- Fig. 3a: einen Regelkreis gemäß Variante 3 des erfindungsgemäßen Verfahrens mit einer induktiv gekoppelten Sonde, bei dem die HF-Signale in Abhängigkeit vom hochfrequente H- oder E-Feld der HF-Spule geregelt werden;
- Fig. 3b: einen Regelkreis gemäß Variante 3 des erfindungsgemäßen Verfahrens mit einer kapazitiv gekoppelten Sonde, bei dem die HF-Signale in Abhängigkeit vom hochfrequente H- oder E-Feld der HF-Spule geregelt werden;
- Fig. 4: eine Sonde in Form eines zu einer Schlaufe gebogenen Koaxialkabels mit auf der Abschirmung gelöteter Seele;
- Fig. 5: einen Regelkreis (Leistungsbegrenzer) nach dem Stand der Technik;
- Fig. 6: eine grafische Auftragung der Verringerung der Breite des Frequenzspektrums eines rechteckförmigen Sendepulses in Abhängigkeit des Verhältnisses der Pulsbreite zur Zeitkonstante (inversproportional zur Güte des Schwingkreises); für die Betrachtung der effektiven Anregungsbreite der Spins müssten noch die Blochgleichungen gelöst werden;
- Fig. 7a: einen HF-Puls mit rechteckiger Pulsform und das daraus resultierende sägezahnförmige B₁-Feld in der Messprobe;
- Fig. 7b: einen HF-Puls mit Preemphase und das daraus resultierende annähernd rechteckförmige B₁-Feld in der Messprobe (Anpassung des HF-Signals über die Dauer eines HF-Pulses);
- Fig. 8a: eine Pulsfolge umfassend Pulse mit gleichen Sendeleistungen und das daraus resultierende abfallende B₁-Feld in der Messprobe;
- Fig. 8b: Pulsfolge umfassend Pulse mit unterschiedlichen Sendeleistungen und das daraus resultierende konstante B₁-Feld in der Messprobe (Anpassung des HF-Signals über die Dauer einer HF-Pulsfolge);
- Fig. 9: Beispiel einer Pulssequenz mit drei Pulsen mit maximaler Sendeleistung - durch die Superposition des zweiten und dritten Pulses mit den ausschwingenden Pulsen wird die Strom/Spannungsgrenze des Probenkopfes überschritten;
- Fig. 10: eine grafische Auftragung der Pulsdauer in Abhängigkeit der Salzkonzentration für einen Messkopf gemäß dem Stand der Technik.

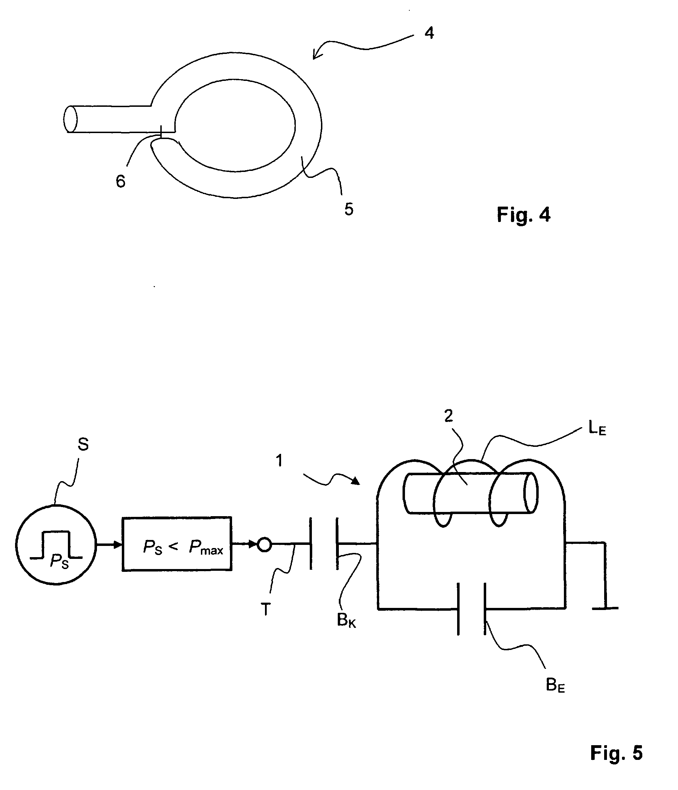

Fig. 5 zeigt einen Regelkreis eines NMR-Messkopfes nach dem Stand der Technik, bei dem die Regelung der Signalleistung *P*s mittels eines festen Grenzwertes, vorzugsweise der Maximalleistung *P*ₘₐₓ, erfolgt, d.h. der Regelkreis funktioniert als einfacher Begrenzer. Ein Puls oder eine Pulssequenz wird im NMR-Spektrometer generiert. Der Regelkreis prüft ob die Sendeleistung innerhalb der für den Messkopf definierten Leistungsgrenzen liegt und erlaubt das Senden lediglich im Falle eines zulässigen Wertes. Der Messkopf umfasst einen Schwingkreis 1 mit einer HF-Spule L_{E} und einem HF-Bauteil B_{E} in Form eines Kondensators. Der Schwingkreis ist über eine Transmissionsleitung T mit dem Sender des Spektrometers S verbunden. Zur Impedanzanpassung des Schwingkreises 1 an die Transmissionsleitung T ist ein zusätzliches HF-Bauteil B_{K} mit dem Schwingkreis 1 in Serie geschaltet. Der Messkopf kann weitere HF-Bauteile enthalten, die hier nicht dargestellt sind.

Die Begrenzung der Sendeleistung auf die Maximalleistung Pₘₐₓ ist zwar als Sicherheitsmaßnahme zum Schutz des Messkopfes sinnvoll, schützt aber auf einem Niveau, das in gewissen Situationen deutlich zu tief, in anderen wiederum nicht ausreichend sein kann.

### Ein Messkopf benötigt bei definierter Anpassung an die

Transmissionsleitungsimpedanz (in der Regel auf 50 Ω) am wenigsten Leistung für das Erreichen einer gewissen Pulsdauer, wenn er leer (bzw. mit verlustloser Messprobe bestückt) ist und die Pulsdauer lang gegenüber der Zeitkonstante des Resonators ist. Je nach Fehlanpassung und Reflexionen in den Komponenten und Transmissionsleitungen T kann der Messkopf sogar weniger Leistung für denselben Strom in der Spule L_{E} benötigen, da der Anteil an reflektierter Leistung P_{R} am Ausgang des Spektrometers (des Sendes) geringer als bei Anpassung an die Impedanz der Transmissionsleitung ausfallen kann. Um diesem Effekt vorzubeugen wird in der Regel der für die Sendeleistung festgelegte Grenzwert mit ausreichender Reserve vorgesehen.

Wird der Messkopf nicht ideal angepasst (erste Situation), so wird in der Regel ein gewisser Anteil der gesendeten Leistung Pₛ am/im Messkopf reflektiert, so dass die in der Sendespule L_{E} zur Verfügung stehende Leistung geringer ist als bei perfekter Anpassung. Damit muss zur Erreichung eines gewünschten Pulswinkels die Pulsdauer bei gleicher Sendeleistung Pₛ länger gewählt werden. Bei hohen Güten Q kann dieser Effekt jedoch auch gerade entgegengesetzt sein (zweite Situation), und die Pulsdauer kann sich bei nomineller Fehlanpassung sogar verkürzen. Dabei ist es entscheidend ob "über- oder unterangepasst" wurde, d.h. die belastete Güte des Resonators höher oder tiefer ist als bei "korrekter" Leistungsanpassung an die Transmissionsleitung.

In dieser ersten Situation kommt die Sendeleistung Pₛ nie vollständig im Messkopf, respektive in der Spule L_{E}, an. Daher sind die Spannungen über den HF-Bauteilen und den Spulen alle niedriger als es prinzipiell möglich wäre, und ein Spannungsdurchschlag ist erst bei höheren Leistungsniveaus zu befürchten. Die zulässige Maximalleistung Pₘₐₓ wird im Messkopf nicht erreicht.

Eine Variante (Variante 1) des erfindungsgemäßen Verfahrens sieht dagegen vor, die reflektierte Leistung P_{R} zu messen und die Sendeleistung Pₛ derart anzupassen, dass nicht die Sendeleistung Pₛ, sondern die Sendeleistung Pₛ minus der reflektierten Leistung P_{R} auf die Leistung Pₛₒₗₗ (Q₀), die im Messkopf dissipiert werden muss, um einen Soll-Pulswinkel bei gegebener Dauer des HF-Signals zu realisieren. Im Falle des kürzesten mit diesem Messkopf realisierbaren Pulses ist Pₛₒₗₗ (Qo) = Pₘₐₓ. Für diese Korrektur der reflektierten Leistung ist die Bestimmung der Güte Q₀ des Schwingkreises ohne Messprobe nicht notwendig.

Eine zweite Situation entsteht, wenn eine verlustbehaftete Messprobe 2 in den Messkopf eingebracht wird. Durch die zusätzlichen Verluste sinkt die Güte Q des belasteten Schwingkreises 1 (Q < Q₀) und damit verringert sich die Resonanzüberhöhung des Stromes: Die Pulswinkel werden bei identischer Sendeleistung Pₛ länger, da ein Teil der Sendeleistung Pₛ in dem Messprobe 2 statt im Messkopf dissipiert wird.

Ziel der Begrenzung der Sendeleistung Pₛ ist ein Schutz des Messkopfes vor Spannungsdurchschlägen, dem Quenchen supraleitender Komponenten, oder dem Durchbrennen von Komponenten durch zu hohen Strom. Da die über der Sendespule L_{E} oder über Bauteilen B_{K} des Abstimmungsnetzwerkes anliegende Spannung aber nicht direkt von der Sendeleistung Pₛ, sondern von mehreren Parametern abhängt, ist dieser Schutz gemäß dem Stand der Technik zu "hart".

Die zusätzliche Dissipation in der Messprobe 2 führt dazu, dass nur ein Teil der Sendeleistung Pₛ im Messkopf und der Rest in der Messprobe 2 dissipiert wird. Da jedoch nicht Leistung, sondern Spannung bzw. Strom den Messkopf zerstören kann und die Spannung im Wesentlichen proportional zum Strom in der Spule bzw. dem Abstimmnetzwerk ist, besteht auch bei Verwendung einer Sendeleistung Pₛ, die höher ist als die Maximalleistung Pₘₐₓ, kein Risiko, den Messkopf zu zerstören. Erfindungsgemäß kann die Sendeleistung Pₛ so weit erhöht werden bis die im Messkopf dissipierte Leistung wieder der Maximalleistung Pₘₐₓ entspricht. D.h. die Sendeleistung darf gleich der Maximalleistung plus der in der Messprobe 2 dissipierten Leistung sein.

Eine Möglichkeit der Bestimmung der in der Messprobe dissipierten Leistung ist die Messung der Güte Q des Schwingkreises mit und das Vergleichen mit der Güte Q₀ ohne Messprobe. Somit kann die Sendeleistung Pₛ = Pₛₒₗₗ (Q) > Pₛₒₗₗ (Q₀) = Pₘₐₓ eingestrahlt werden ohne Spannungsdurchschläge im Messkopf fürchten zu müssen.

Wird die Sendeleistung dementsprechend angepasst, so erzielt das NMR Spektrometer dieselbe Pulsdauer mit jeder Messprobe und bei jeder Abstimmung (im Rahmen der zur Verfügung stehenden Gesamtleistung und der zulässigen Reflexionen). Zulässig sind Reflexionen, wenn die weiteren Komponenten auf dem Sendepfad keinen Schaden nehmen, d.h. beispielsweise keine Spannungsdurchschläge im Sende-/Empfangsschalter oder in Filtern auftreten können beziehungsweise der Leistungsverstärker de Senders selbst Schaden nimmt.

Eine dritte Situation entsteht insbesondere bei Messköpfen mit supraleitenden Materialien, wenn diese nahe an ihrem kritischen Strom betrieben werden und bei Spulen aus konventionellen Leitermaterialien, wenn sich die Temperatur des Leiters über die Dauer eines Pulses oder einer Pulssequenz aufgrund der im Schwingkreis 1 dissipierten Leistung ändert.

In diesen Fällen ändert sich der Widerstand der Spule L_{E} als Funktion des Stromes in der Spule L_{E}, so dass sich die Resonatorgüte Q und damit auch die Anpassung unter Last ändern. In der Regel führt dies dazu dass Pulswinkel bei höherer Sendeleistung länger als invers proportional zur Wurzel der Sendeleistung werden. Dieser Effekt wird als Leistungsabhängigkeit der Güte bezeichnet. Besonders störend ist dieser Effekt bei sogenannten geshapeden Pulsen, d.h. Pulsen, bei denen die Amplitude und Phase über die Pulslänge variiert wird, da die berechneten Pulse sich zum Teil deutlich von den effektiv gesendeten Pulsen unterscheiden können und damit die Spinoperationen nicht mehr korrekt ausgeführt werden. Neben den Amplitudenfehlern können auch Phasenfehler durch eine Leistungsabhängigkeit von Komponenten im Sendepfad auftreten.

Um diese Nichtlinearitäten korrigieren zu können, müssen diese vermessen und in einer Korrekturtabelle abgelegt werden. Problematisch ist hierbei, dass die Nichtlinearitäten nicht alleine von der Sendeleistung Pₛ sondern vom Strom in den kritischen Bauteilen abhängen. Letzerer ist jedoch nicht nur ein Parameter der Sendeleistung Pₛ sondern auch der Abstimmung (Tuning/Matching) sowie der Verluste an der Messprobe 2. Eine einfache Korrekturtabelle löst folglich das Problem nur partiell.

Sinnvoller für diese Aufgabe ist daher eine andere Variante der Erfindung (Variante 2), bei der die Sendeleistung solange erhöht wird, bis der Pulswinkel einen Sollwert αₛₒₗₗ bei gegebener Pulsdauer P₁ erreicht. Nachteilig bei dieser Methode ist, dass eine NMR-Messung des Pulswinkels mit sinnvollem Zeitaufwand (einem Bruchteile der effektiven Messzeit mit der Messprobe) durchführbar sein muss. Weiterhin ist die Korrektur von geshapeten pulsen quasi unmöglich durchzuführen und das Verfahren damit lediglich auf Hartpulse anwendbar.

Die dritte Variante der Erfindung bietet über eine elegante Lösung der Problematik eines effizienter Schutzes des Messkopfes vor Zerstörung durch zu hohe Sendeleistungen hinaus noch weitere Vorzüge eines vollständig automatisierbaren "intelligenten" NMR-Sendesystems. Bei dieser dritten Variante wird im Messkopf mittels einer Sonde eine Messung eines Parameters durchgeführt, der eine bekannte oder bestimmbare Abhängigkeit vom in der Messprobe erzeugten Hochfrequenzfeld hat. Eine Regelung der Sendesignale mittels dieses Parameters erlaubt Korrekturen jeglicher, z.B. durch Imperfektionen der Apparatur entstehender Abweichungen und somit im Rahmen der Möglichkeiten bei der Erzeugung von HF-Pulsen das Senden exakt vorbestimmbarer HF-Felder. Der Schutz des Messkopfes vor Spannungsdurchschlägen ist in dieser Variante nur ein Aspekt der Möglichkeiten.

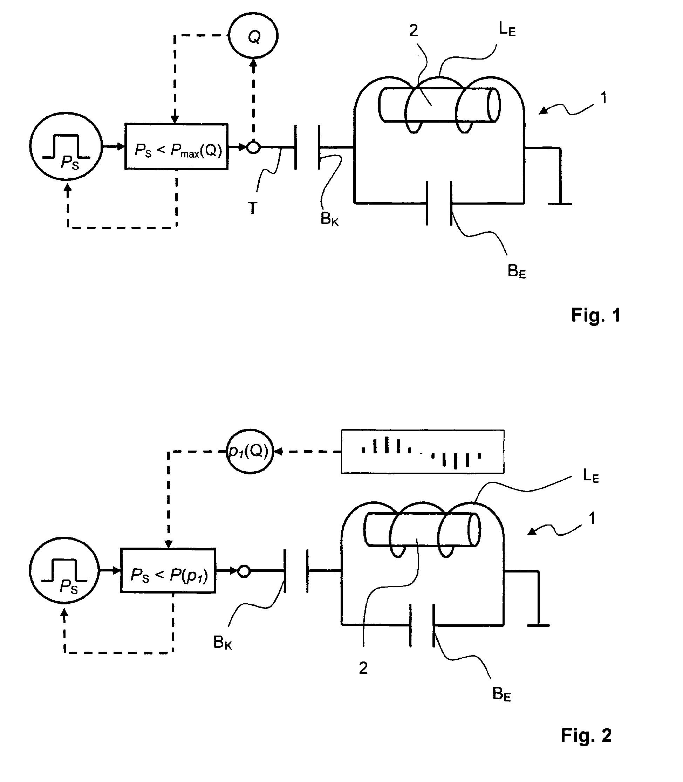

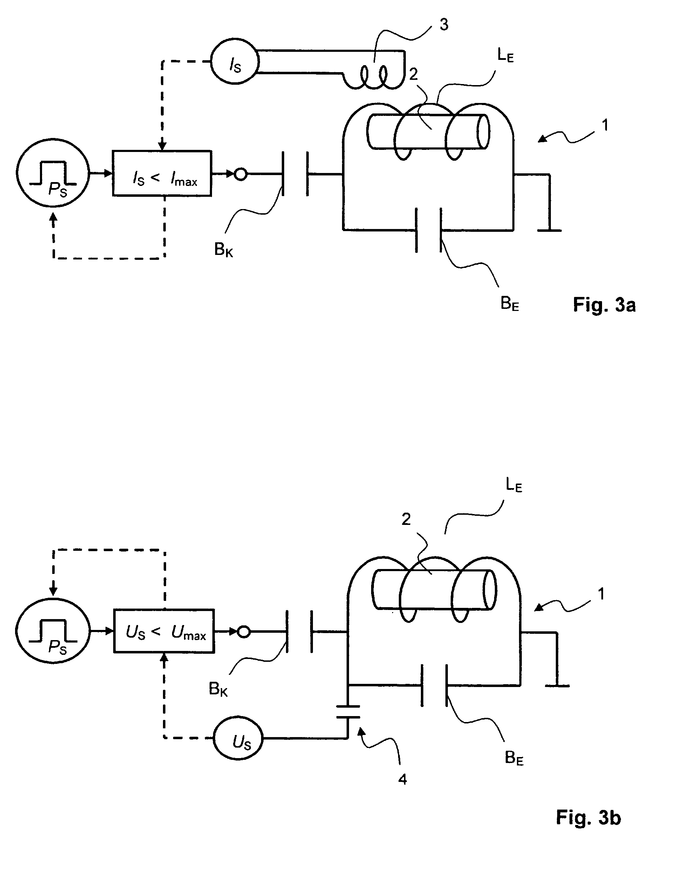

Um den Messkopf auch dann noch vor Spannungsdurchschlägen zu schützen, wenn eine Sendeleistung Pₛ über der Maximalleistung Pₘₐₓ zugelassen wird, gibt es erfindungsgemäß folglich mehrere Möglichkeiten:
Variante 1:
   Die Güte Q des HF-Schwingkreises 1 und/oder die Impedanzanpassung des HF-Schwingkreises 1 an die Transmissionsleitung T wird gemessen und die Sendeleistung P_{S} dementsprechend angepasst (Fig. 1).
Variante 2:
   Die Sendeleistung P_{S} wird solange erhöht, bis die kürzeste erlaubte Pulsdauer pₘᵢₙ erreicht ist, wobei die kürzeste erlaubte Pulsdauer pₘᵢₙ dann erreicht wird, wenn die zulässige Maximalleistung Pₘₐₓ, d.h. die Leistung, bei der die HF-Bauteile gerade nicht zerstört werden, im Messkopf dissipiert wird (Fig. 2).
Variante 3:
   Das von der Sendespule erzeugte Feld wird gemessen und die Sendeleistung solange erhöht bis die zulässige Maximalleistung erreicht ist (Fig. 3a, 3b).

Allen Varianten gemeinsam ist, dass mit Hilfe eines NMR-Probenkopfs eine Messung eines Parameters durchgeführt wird, über den der Strom in oder die Spannung über einem der HF-Bauteil B_{E}, L_{E}, B_{K} (kritisches Bauteil) bestimmt werden kann und dass die Sendeleistungen P_{S}, in Abhängigkeit des gemessenen Parameters geregelt wird. Die Sendeleistung P_{S} der HF-Signale kann dadurch derart begrenzt werden, dass in keinem der HF-Bauteile oder HF-Spulen die maximal erlaubten Strom- und Spannungswerte, d.h. Strom- und Spannungswerte, die gerade noch nicht zur Zerstörung des betreffenden Bauteils führen könnten, überschritten werden.

Ein Probenkopf, mit dem das erfindungsgemäße Verfahren durchgeführt werden kann, umfasst mindestens einen HF-Schwingkreis 1, der mittels HF-Bauteilen B_{E} auf die Frequenz einer zu untersuchenden Kernart abgestimmt ist. Dieser mindestens eine HF-Schwingkreis 1 enthält mindestens eine HF-Spule L_{E}, die um eine Messprobe 2 angeordnet ist und bestimmte Kernspins im Probenbehälter anregen, und das daraus resultierende NMR-Signal empfangen kann. Der NMR-Probenkopf kann auch zusätzliche HF-Bauteile B_{K} enthalten, die Bestandteile von HF-Schwingkreisen 1, von Koppel- sowie von Filternetzwerken sein können. Der NMR-Probenkopf besitzt mindestens einen Anschluss zur jeweiligen Einspeisung eines HF-Signals, mit dem bestimmte Kernspins in der Messprobe 2 mit Hilfe der HF-Spulen L_{E} angeregt werden können.

Über die Begrenzung der Sendeleistung hinaus erlauben alle drei Verfahren noch weitere Korrekturen:
- Im ersten Verfahren können Pulswinkel durch Messung von Güte und Reflexion ohne die experimentelle Bestimmung eines Pulswinkels mittels eines NMR-Signals vorbestimmt werden.
- Im zweiten Verfahren können Nichtlinearitäten, die gepulsten Betrieb auftreten korrigiert werden.
- Im dritten Verfahren können ohne Messung eines NMR-Signals nicht nur beliebige HF-Pulse bestimmt sondern auch Fehler z.B. durch Nichtlinearitäten, Leistungsabhängigkeiten, Superposition von Signalen, Einschwingvorgänge etc. korrigiert werden.

Ein Regelkreis, der für die erste Variante verwendet werden kann, ist in Fig. 1 dargestellt. Die Güte Q wird z.B. über die Bandbreite einer Absorptionskurve beim Sweepen der Frequenz eines quasi-cw (continous wave) Signals bestimmt.

Vorteil der Variante 1 ist es, dass bereits vor dem Senden des ersten Pulses die richtige Sendeleistung bestimmt werden kann. D.h. eine Pulswinkelbestimmung erübrigt sich prinzipiell, falls die Güte Q und die Anpassung ausreichend präzise gemessen werden. Nachteilig ist, dass diese Messungen in der Regel quasi-cw durchgeführt werden und der Strom in einem Schwingkreis mit Güte Q nicht instantan steigen kann. Dadurch ist insbesondere bei kurzer Pulsdauer weniger Strom im Schwingkreis als bei langer oder sehr langer (quasi-cw) Pulsdauer, vor allem dann wenn die Güte Q sehr hoch ist. D.h. ein bedeutender Teil der gesendeten Welle wird an der Sendespule L_{E} reflektiert. Die Korrekturen, die hierfür benötigt werden, können allerdings berechnet werden. Alternativ kann die gesendete und reflektierte Welle mittels Richtkoppler gemessen werden, so dass eine gemessene Korrektur erfolgen kann.

Fig. 2 zeigt einen Regelkreis, mit dem die Variante 2 ausgeführt werden kann.

Der Vorteil der Variante 2 liegt darin, dass die exakt richtigen Pulswinkel für die Messprobe 2 bestimmt werden. Dies wird am sinnvollsten mit einer automatischen Routine durchgeführt, die die Sicherheitsbegrenzung für den Probenkopf übernimmt. Als Startwert Pₛ₀ für die Sendeleistung Pₛ kann die Maximalleistung Pₘₐₓ gewählt werden, der Pulswinkel bestimmt werden und dann die Sendeleistung Pₛ so erhöht werden, dass die Pulsdauer auf einen definierten Sollwert p₁(Q) eingestellt wird (Pₛ<P(p₁)). Da der Strom im Resonator (indirekt) gemessen wird, kann die Leistung P(p₁) auch größer sein als Pₘₐₓ. Alternativ hierzu kann auch die Pulsdauer variiert werden, bis der Pulswinkel auf einen definierten Sollwert eingestellt wird. Zur Bestimmung des Pulswinkels wird ein HF-Puls mit dem Startwert Pₛ₀ der Sendeleistung eingestrahlt und das daraus resultierende NMR-Signal aufgenommen.

Diese Variante 2 garantiert einen genau bestimmten Pulswinkel, allerdings nur dann, wenn die Messprobe ausreichend Signal zur Verfügung stellt, dass eine Pulswinkelbestimmung in einem vertretbaren Zeitrahmen möglich ist. Hier gilt es allerdings zu bedenken, dass eine Bestimmung der Pulswinkel auch dann notwendig ist, wenn die Pulsdauer und nicht die Pulsleistung angepasst werden soll.

Ein Nachteil der Variante 2 ist der zeitliche Aufwand der Bestimmung der Pulswinkel für übliche Messproben. In vielen Situationen ist eine effektive Bestimmung der Pulswinkel mangels eines ausreichenden Signals schlichtweg nicht möglich. Die Variante 2 des erfindungsgemäßen Verfahrens wird daher wohl hauptsächlich zu Kalibrationszwecken einer der beiden anderen Methoden eingesetzt werden.

Die Variante 3 vereint die Vorzüge der ersten beiden Varianten. Eine Bestimmung des von der Sendespule L_{E} erzeugten Magnetfeldes ermöglicht eine genaue Bestimmung des Pulswinkels auch dann, wenn das Signal/Rausch-Verhältnis der Messprobe 2 (oder die Relaxationszeiten) die Messung eines NMR-Spektrums in sinnvollem zeitlichen Rahmen nicht ermöglichen. Weiterhin wäre es möglich, bei einem in-situ monitoring des Sendefeldes (H- oder E-Feld) das Senden abzubrechen oder die Leistung des Sendepulses zu clippen, wenn die Maximalleistung überschritten wird und die Spannungen im Schwingkreis einen Pegel erreichen, bei dem ein Durchschlagen oder Durchbrennen eines kritischen Bauteils zu befürchten ist.

Eine solche in-situ-Feldmessung kann z.B. durch eine kapazitiv oder induktiv gekoppelte Sonde zur durchgeführt werden. Fig. 3a zeigt einen Regelkreis mit induktiv an der HF-Spule L_{E} gekoppelten Sonde 3, Fig. 3b einen Regelkreis mit kapazitiv an den Schwingkreis gekoppelten Sonde 4.

Die Ankopplung der Sonden 3, 4 kann induktiv und kapazitiv sowohl an jedem der HF-Bauteile B_{K} und B_{E} sowie der Spule L_{E} als auch an Streufeldern, insbesondere am elektrischen oder magnetischen Streufeld der Spulen L_{E} erfolgen.

Bei einem Messkopf mit mehr als einer Messfrequenz kann eine solche Sonde 3, 4 mit allen Kanälen leicht gekoppelt und entsprechend breitbandig ausgeführt sein, so dass die Felder aller Kanäle bestimmt werden können. Eine konkrete Ausführungsform um das H-Feld zu messen wäre z.B. eine Pickupschlaufe, die eine sehr schwache induktive Kopplung zu allen Sendespulen L_{E} aufweist. Falls die Transmission im Bereich ca. -30 dB bis -70 dB liegt, dann kann die Empfangselektronik des Spektrometers, d.h. der NMR-Receiver mit dem normalerweise die detektierten NMR-Signale verarbeitet werden, direkt zur Feldmessung verwendet werden. Falls die Kopplung zu stark sein sollte, kann ein Dämpfungsglied zwischen der Pickup-Schlaufe und dem Vorverstärker bzw. dem Spektrometereingang verschaltet werden. Eine hauptsächlich kapazitiv koppelnde Sonde 4 kann z.B. als offenes Koaxialkabel mit leicht überstehender Seele ausgeführt sein kann. Alternativ dazu kann eine kleine Kondensatorplatte, welche an die elektrischen Felder der verschiedenen Sendespulen L_{E} koppelt, eingebaut werden oder ein Kondensator mit geringer Kapazität mit den Sendespulen L_{E} oder andere HF-Bauteile verbunden werden. Fig. 4 zeigt eine Sonde 3, die im Wesentlichen nur mit den magnetischen Feldern koppelt. Dies wird im gezeigten Beispiel mittels einer Abschirmung erzielt. Dabei kann z.B. ein Koaxialkabel 5 zu einer Schlaufe gebogen und die Seele 6 auf die Abschirmung des Koaxialkabels gelötet werden. Die Breitbandigkeit der Sonde kann durch weitestgehend korrektes Abschließen auf 50 Ω und eine geringe Induktivität erreicht werden.

Eine weitere Möglichkeit ist die Verwendung der residuellen Kopplung zwischen den verwendeten Spulen L_{E} bzw. Sende-/Empfangskanälen bei einem Messkopf für mehrere Messfrequenzen. Ein solcher Kopf weist einen oder mehrere Sende/Emfpangskanäle pro Messfrequenz auf. So kann z.B. das Senden auf dem Protonenkanal über den Carbonkanal gemessen werden oder bei zwei oder mehreren vorhandenen Protonenkanälen (in "Quadratur" oder als "Array") von einem in einen anderen Kanal gleicher Messfrequenz gemessen werden. Nachteilig ist, dass in der Regel die Messköpfe so aufgebaut werden, dass ein simultanes Entkoppeln während der Messung auf einer anderen Messfrequenz möglich ist, so dass die Transmission zwischen den Kanälen in der Regel mit extrem hoher Dämpfung ausgeführt wird. Diese Dämpfung wird in der Regel zumindest teilweise durch Filter erreicht. Nur wenn ein Abgriff vor den Filtern möglich ist, kann die jeweils andere Sende/Emfpangsspule zur Feldmessung des Sendefeldes verwendet werden.

Die in-situ Feldmessung der Variante 3 hat im Vergleich zu allen Messungen außerhalb der Sendespule L_{E} den großen Vorzug, dass nicht eine Überlagerung aus gesendeter und reflektierter Welle gemessen wird sondern eine direkte Messung des Stromes/Spannung im kritischen Bauteil möglich ist.

Der größte Vorzug dieser Methode besteht darin, dass die exakten Pulswinkel für ein Experiment ohne NMR-Messung bestimmt werden können. Zu diesem Zweck muss lediglich ein "Dummyscan", d.h. die Pulsfolge ohne Aufnahme der Antwort des Systems im Receiver mit gleichzeitiger Feldmessung durchgeführt werden. Aus dieser Feldmessung können die korrekten Pulswinkel bestimmt werden. Dieses Verfahren funktioniert für beliebige Messproben mit beliebigen elektrischen Verlusten auch dann exakt, wenn die Messköpfe nichtlinear in Bezug auf die Sendeleistung Pₛ sind, d.h. die Pulswinkel nicht invers proportional von der Wurzel der Sendeleistung abhängen, die Abstimmung ungenau ist und vor allem wenn die Messprobe 2 zu wenig Messsubstanz enthält um auf einer Messfrequenz die Pulswinkeln in kurzer Zeit bestimmen zu können.

Ein weiterer Vorteil der Variante 3 besteht darin, dass die exakte Pulsform bestimmt werden kann und Pulsverzerrungen mittels Preemphase korrigiert werden können.

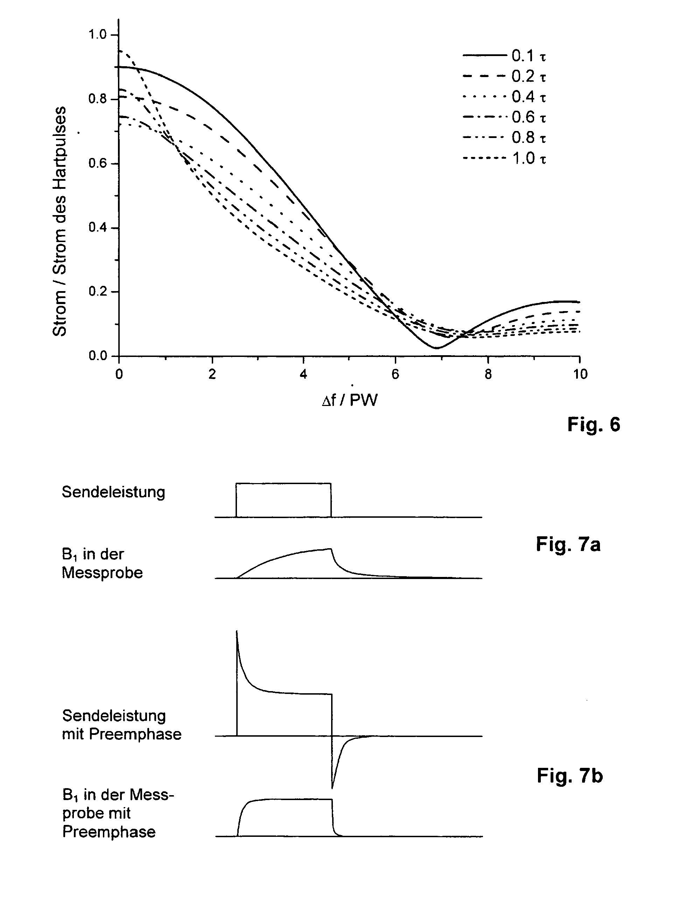

Dies kann notwendig werden, um eine maximale Anregungsbreite bei Probenköpfen mit sehr hohen Güten Q erreichen zu können. Wenn die Zeitkonstante der Resonatoren in der Größenordnung der gewünschten Pulslängen liegt, verändert sich die effektive Pulsform von einem Rechteckpuls in eine Art Sägezahnpuls (Fig. 7a). Die effektive Anregungsbreite eines solchen Pulses ist im Grenzfall nicht mehr von der nominellen Pulslänge sondern lediglich der Zeitkonstante des Schwingkreises 1 gegeben. In Fig. 6 ist die Verringerung der Spektralbreite in Abhängigkeit der Pulsdauer für verschiedene Verhältnisse der Pulsdauer zur Zeitkonstante des Schwingkreises dargestellt. Dabei wurde bei konstanter Pulsdauer die Güte Q des Schwingkreises 1 erhöht. Die effektive Anregungsbreite im NMR unterscheidet sich noch von der in Fig. 6 dargestellten Spektralbreite des Pulses, da die Blochgleichungen für das Spinsystem gelöst werden müssen.

Um eine breitere Anregung erreichen zu können, wird erfindungsgemäß kein Rechteckpuls gesendet, sondern mittels Preemphase ein annähernd rechteckförmiger Strompuls in der Spule L_{E} generiert (Fig. 7b). Dabei werden insbesondere zu Beginn des Pulses Sendeleistungen notwendig, die ein Vielfaches der nominellen Maximalleistung Pₘₐₓ des Messkopfes betragen können. Eine in-situ Messung der kritischen Spulenparameter (E- oder B-Feld) erlauben die risikolose Verwendung solch hoher Sendeleistungen. Desweiteren begünstigt eine exakte Messung der erzeugten Pulsform eine Anpassung der Sendeleistung Pₛ, da in diesem Falle auch die Ein- und Ausschwingzeiten der gesamten Verstärkerkette und Filter im Sendepfad berücksichtigt werden. Dies ist nicht der Fall, wenn lediglich die gemessene Spulengüte Q in die Berechnung der Preemphase eingeht.

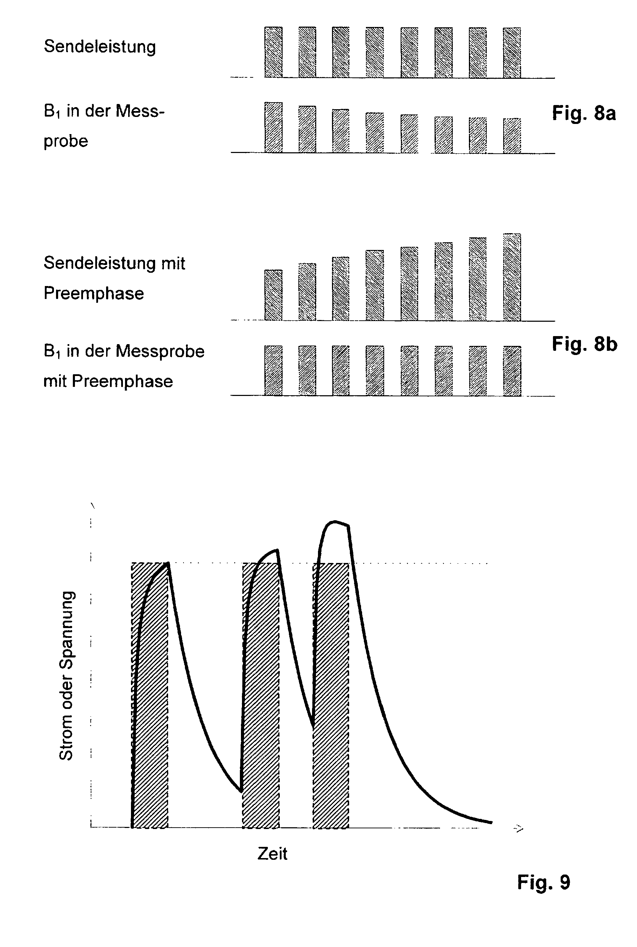

Zusätzlich zu diesen Vorteilen können typische Artefakte aufgrund von Heizeffekten des Netzwerkes oder Nichtlinearitäten der Spulen L_{E} mittels der erfindungsgemäßen In-situ-Messung korrigiert werden. Bei manchen Pulssequenzen führt die im Probenkopf dissipierte Leistung zu einer Verstimmung des Schwingkreises über die Zeitdauer des Experimentes (Fig. 8a). Dieses Problem kann nicht durch die Reduktion des Duty-Cycles, d.h. des Verhältnisses von Pulsdauer zu Wartezeit zwischen Pulsen gelöst werden. Werden die Pulse aufgrund des Verschiebens des Arbeitspunktes des Messkopfes, d.h. einer Veränderung der Frequenzanpassung an die Sendefrequenz und/oder der lmpedanzanpassung an die Transmissionsleitung, nicht mehr korrekt ausgeführt, können entweder Artefakte (z.B. Phasenfehler) oder Signalverlust daraus resultieren. Bei dem erfindungsgemäßen in-situ Monitoring der erzeugten B-Felder kann das Spektrometer diese Effekte korrigieren, indem über die Dauer der Pulssequenz für dieselben Pulse verschiedene Sendeleistungen Pₛ, eventuell auch andere Sendephasen verwendet werden, wie in Fig. 8b gezeigt. Hier wurden Effekte der Güte Q auf die Pulsform vernachlässigt.

Wird der Abstand zwischen den Pulsen kurz in Bezug auf die Zeitkonstante des Resonators gewählt, so kumuliert der Messkopf Leistungen, die zur Zerstörung führen können. Ein weiterer Vorteil der in-situ Messung der kritischen Spulenparameter ist, dass in diesem Falle die kumulierten Ströme/Spannungen im Resonator berücksichtigt werden und nicht nur die Sendeleistung Pₛ. Eine derartige Situation veranschaulicht Fig. 9. Die schraffierten Blöcke stellen die gesendeten Pulse dar, d.h. Strom /Spannung in der Spule für den Fall sehr geringer Spulengüten. Die durchgezogene dicke Linie stellt den Strom oder die Spannung bei einer Zeitkonstante der Spule dar, die in der Größenordnung der Pulsdauer liegt. Mittels Preemphase kann nun die Pulsform jedes einzelnen Pulses (und damit auch das Ausschwingen) korrigiert werden. Ist eine schnelle Preemphase über einen einzelnen Puls hinweg nicht möglich, so kann zumindest die Sendeleistung der einzelnen Pulse so angepasst werden, dass der/die kumulierte Strom/Spannung in den kritischen Bauteilen des Messkopfes nie den zulässigen Grenzwert überschreitet.

Wird die in-situ Messung der kritischen Spulen-/Netzwerkparameter (Strom/Spannung) nicht breitbandig ausgeführt, so wird bei zeitgleicher Anregung auf verschiedenen Frequenzen die kumulierte Spannung bzw. der kumulierte Strom nicht detektiert, so dass ein zuverlässiger Schutz nur durch das rechnerische Addieren der detektierten Parameter gewährleistet ist. Damit dies zuverlässig möglich ist, müssen die Orte der möglichen Superposition von Strömen bzw. Spannungen und das Verhältnis der erzeugten Amplituden zwischen Messort und der Position der stärksten Superposition bei jeder Messfrequenz bekannt sein. Im Stand der Technik wird dieser Fall nicht berücksichtigt, so dass die zulässigen Sendeleistungen in der Regel manuell um einen Faktor zwei bis vier reduziert werden müssen. Ein Schutz des Messkopfes ist folglich entweder nicht gegeben oder die Sendeleistung Pₛ wird vorsichtshalber auf die Hälfte oder sogar nur ein viertel der Maximalleistung Pₘₐₓ begrenzt, was jedoch in vielen Fällen gar nicht in dem Maße notwendig gewesen wäre.

Mit dem erfindungsgemäßen Verfahren kann die Signalleistung Pₛ des HF-Signals derart begrenzt, dass in keinem der Hochfrequenzbauteile L_{E}, B_{E}, B_{K} die maximal erlaubten Strom- und Spannungswerte, die zur Zerstörung des betreffenden Bauteils führen könnten, überschritten werden.

### Bezugszeichenliste

- 1: Schwingkreis
- 2: Probe
- 3: Induktiv gekoppelte Sonde
- 4: Kapazitiv gekoppelte Sonde
- 5: Koaxialkabel
- 6: Seele
- B_{E}: HF-Bauteil des Schwingkreises
- B_{K}: Zusätzliches HF-Bauteil
- L_{E}: HF-Spule
- Pₛ: Sendeleistung ist die nominelle Leistung, die vom Sender abgegeben wird (Signalleistung).
- P_{R}: Reflektierte Leistung ist der Teil der Leistung, der am Probenkopf reflektiert wird und nie in der Sendespule ankommt.
- Pₛₒₗₗ (Qo): diejenige Leistung, die im Messkopf dissipiert werden muss, um einen Soll-Pulswinkel bei gegebener Dauer des HF-Signals zu realisieren wenn der Messkopf mit einer verlustlosen oder keiner Messprobe bestückt ist
- Pₛₒₗₗ (Q): diejenige Leistung, die im Messkopf dissipiert werden muss, um einen Soll-Pulswinkel bei gegebener Dauer des HF-Signals zu realisieren, wenn der Messkopf mit einer beliebigen Messprobe bestückt ist.
- *P*ₘₐₓ: Maximalleistung = diejenige Leistung, bei der an den kritischen Bauteilen des Probenkopfs eine so große Spannung anliegt und bei der durch das kritische Bauteil ein so großer Strom fließt, dass das kritische Bauteil gerade noch nicht zerstört wird. Wenn die Maximalleistung im Messkopf dissipiert wird, wird der kleinste mögliche Pulswinkel erreicht.
- *_{Pmin}*: kürzeste zulässige Pulsdauer für einen 90° Puls
- *P* ₁*(Q)*: Pulsdauer in Abhängigkeit der Güte des Resonators (in Fig. 2 ist dies ein gemessener Wert, prinzipiell kann der Wert der ,Pulsdauer aber auch berechnet werden)
- P(ₚ₁): zu einem Puls mit bestimmtem Flipwinkel und Dauer gehörige Leistung (Da der Strom im Resonator (indirekt) gemessen wird, kann diese Leistung bei Variante 2 auch größer sein als Pₘₐₓ)
- S: Spektrometer
- T: Transmissionsleitung

## Patentansprüche

1. Verfahren zur Regelung von Hochfrequenz (HF)-Signalen in einem Kernspinmagnetresonanz (NMR) System umfassend ein Spektrometer, einen Regelkreis und einen NMR-Probenkopf, wobei
- das Spektrometer einen Sender umfasst, der HF-Signale auf Messfrequenzen mit einer Sendeleistung (P_{S}) sendet,
- der NMR-Probenkopf mindestens einen HF-Schwingkreis enthält, der mittels erster HF-Bauteile (B_{E}) auf die Resonanzfrequenz einer zu untersuchenden Kemart abgestimmt ist,
- der HF-Schwingkreis mindestens eine HF-Spule (L_{E}) umfasst, die um eine Messprobe angeordnet ist und durch Aussenden der HF-Signale zum Anregen von Kemspins in einer Probe und zum Empfangen von aus dieser Anregung resultierenden NMR-Signalen dient, und
- der NMR-Probenkopf weitere HF-Bauteile (B_{K}) enthalten kann, die Bestandteile des HF-Schwingkreises, von Koppel- sowie von Filternetzwerken sein können,
wobei mit Hilfe des NMR-Probenkopfs eine Messung eines Parameters durchgeführt wird, über den der Strom in oder die Spannung über der HF-Spule (L_{E}) oder einem der ersten HF-Bauteile (B_{E}) oder gegebenenfalls einem der weiteren HF-Bauteile (B_{K}) bestimmt werden kann,
wobei der Regelkreis die Sendeleistung (P_{S}) in Abhängigkeit des gemessenen Parameters regelt und begrenzt,
**dadurch gekennzeichnet,**
**dass** maximal erlaubte Strom- und/oder Spannungswerte in/über der HF-Spule (L_{E}) oder einem der ersten HF-Bauteilen (B_{E}) oder gegebenenfalls einem der weiteren HF-Bauteile (B_{K}) festgelegt werden, die gerade noch nicht zur Zerstörung der HF-Spule (L_{E}) bzw. des ersten HF-Bauteiles (B_{E}) bzw. des weiteren HF-Bauteils (B_{E}, L_{E}, B_{K}) führen, wobei der Regelkreis die Sendeleistung (P_{S}) so lange erhöht, bis die maximal erlaubte Strom-und/oder Spannungswerte gerade nicht überschritten werden.

2. Verfahren nach Anspruch 1, **dadurch gekennzeichnet, dass** als Parameter die Güte des HF-Schwingkreises und/oder die Impedanzanpassung des HF-Schwingkreises an eine Transmissionsleitung gemessen wird/werden.

3. Verfahren nach Anspruch 1, **dadurch gekennzeichnet, dass** als Parameter die Pulsdauer eines HF-Pulses mit gewünschtem Pulswinkel gemessen wird.

4. Verfahren nach Anspruch 3, **dadurch gekennzeichnet, dass** die Pulsdauer durch Detektion mindestens eines NMR-Signals mittels des NMR-Spektrometers ermittelt wird.

5. Verfahren nach Anspruch 4, **dadurch gekennzeichnet, dass** ein Startwert (P_{S0}), vorzugsweise die Maximalleistung (Pₘₐₓ), für die Sendeleistung (P_{S}) gewählt wird, dass das NMR-Signal mittels des NMR-Spektrometers aufgenommen wird, wobei ein HF-Puls mit dem Startwert (P_{S0}) der Sendeleistung eingestrahlt wird; dass mittels des aufgenommenen NMR-Signals der Pulswinkel des zur Erzeugung des NMR-Signals eingestrahlten HF-Pulses ermittelt wird,
und dass durch diesen ermittelten Pulswinkel die Sendeleistung P_{S} des HF-Pulses mit gewünschtem Pulswinkel und gewünschter Pulsdauer bestimmt wird.

6. Verfahren nach Anspruch 1, **dadurch gekennzeichnet, dass** als Parameter das von der HF-Spule erzeugte hochfrequente H- oder E-Feld gemessen wird.

7. Verfahren nach Anspruch 6, **dadurch gekennzeichnet, dass** die Sendeleistungen (P_{S}) und/oder die Phasen der HF-Signale über die Dauer einer Pulsfolge angepasst werden, wobei während der Pulsfolge mehrere Messungen des von der HF-Spule erzeugte hochfrequenten H- bzw. E-Felds durchgeführt werden.

8. Verfahren nach Anspruch 6, **dadurch gekennzeichnet, dass** die Sendeleistungen (P_{S}) und/oder die Phasen der HF-Signale über die Dauer eines einzelnen Pulses angepasst wird, wobei das von der HF-Spule erzeugte hochfrequenten H- bzw. E-Feld in Abhängigkeit von der Zeit gemessen wird.

9. Verfahren nach Anspruch 8, **dadurch gekennzeichnet, dass** die Regelung der Sendeleistung (P_{S}) über die Dauer eines Pulses so ausgeführt wird, dass die damit erzeugte HF-Pulsform mit einer vorher festgelegten Pulsform übereinstimmt.

10. Kernspinresonanz(NMR)-System zur Durchführung eines Verfahren gemäß einem der Ansprüche 6 bis 9 umfassend
- ein Spektrometer mit einem Sender, der dazu eingerichtet ist, HF-Signale auf Messfrequenzen mit einer Sendeleistung (P_{S}) zu senden,
- einen NMR-Probenkopf mit mindestens einen HF-Schwingkreis, der mittels erster HF-Bauteile (B_{E}) auf die Resonanzfrequenz einer zu untersuchenden Kernart abgestimmt ist,
wobei der HF-Schwingkreis eine HF-Spule (L_{E}) umfasst, die um eine Messprobe angeordnet ist und durch Aussenden der HF-Signale zum Anregen von Kemspins in der Probe und zum Empfangen von aus dieser Anregung resultierenden NMR-Signalen dient,
wobei der Probenkopf weitere HF-Bauteile (B_{K}) enthalten kann, die Bestandteile von HF-Schwingkreisen, von Koppel- sowie von Filternetzwerken sein können, und
- genau eine Messsonde, die zur Messung des hochfrequenten H-Feldes, das von der HF-Spule erzeugt wird, eingerichtet ist, über das der Strom in oder die Spannung über der HF-Spule (L_{E}) oder den ersten HF-Bauteilen (B_{E}) oder weiteren HF-Bauteilen (B_{K}) bestimmt werden kann, wobei die Sonde an die HF-Spule (L_{E}) induktiv gekoppelt ist, und
- einen Regelkreis zur Regelung und Begrenzung der Sendeleistung (P_{S})
in Abhängigkeit des gemessenen Feldes, wobei der Regelkreis dazu eingerichtet ist, die Sendeleistung (P_{S}) so lange zu erhöhen, bis maximal erlaubte Strom- und/oder Spannungswerte in/über der HF-Spule (L_{E}) oder mindestens einem der ersten HF-Bauteile (B_{E}) oder gegebenenfalls einem der weiteren HF-Bauteile (B_{K}), die gerade noch nicht zur
Zerstörung der HF-Spule (L_{E}) bzw. des ersten HF-Bauteils (B_{E}) bzw. des weiteren HF-Bauteils (B_{E}, L_{E}, B_{K}) führen, gerade nicht überschritten werden.

## Claims

1. Method for regulating radio frequency (RF) signals in a nuclear magnetic resonance (NMR) system, comprising a spectrometer, a control loop, and an NMR probe head, wherein
- the spectrometer comprises a transmitter that transmits RF signals at measuring frequencies with a transmission power (P_{S}),
- the NMR probe head contains at least one RF oscillating circuit which is tuned by means of first RF components (B_{E}) to the resonance frequency of a type of nucleus to be investigated,
- the RF oscillating circuit comprises at least one RF coil (L_{E}) which is disposed around a measuring sample and, by emitting RF signals, is used to excite the nuclear spins in a sample and receive NMR signals resulting from this excitation, and
- the NMR probe head may contain further RF components (B_{K}) which may be components of the RF oscillating circuit, of the coupling and filter networks,
wherein measurement of a parameter is performed by means of the NMR probe head, via which parameter the current in or the voltage over the RF coil (L_{E}) or one of the first RF components (BE) or, as the case may be, one of the further RF components (B_{K}) can be determined,
wherein the control loop controls and limits the transmission power (P_{S}) in dependence on the measured parameter,
**characterized in that** maximum permissible current and/or voltage values are determined in/over the RF coil (L_{E}) or one of the first RF components (BE) or, as the case may be, one of the further RF components (B_{K}), wherein the determined values are just below those at which the RF coil (L_{E}) or the first RF component (BE) or the further RF component (BE, L_{E}, B_{K}) are destroyed, wherein the control loop increases the transmission power (P_{S}) to values that just do not exceed the maximum permissible current and/or voltage values.

2. Method according to claim 1, **characterized in that** the Q-value of the RF oscillating circuit and/or the impedance adjustment of the RF oscillating circuit to a transmission line is/are measured as the parameter.

3. Method according to claim 1, **characterized in that** the pulse duration of an RF pulse with desired pulse angle is measured as the parameter.

4. Method according to claim 3, **characterized in that** the pulse duration is determined by detecting at least one NMR signal by means of the NMR spectrometer.

5. Method according to claim 4, **characterized in that** an initial value (P_{S0}), preferably the maximum power (Pₘₐₓ), is selected for the transmission power (P_{S}), the NMR signal is recorded by the NMR spectrometer, wherein an RF pulse with the initial value (P_{S0}) of the transmission power is irradiated, the pulse angle of the RF pulse irradiated for generating the NMR signal is determined by means of the recorded NMR signal,
and the transmission power P_{S} of the RF pulse with desired pulse angle and desired pulse duration is determined by the determined pulse angle.

6. Method according to claim 1, **characterized in that** the radio frequency H or E field generated by the RF coil is measured as the parameter.

7. Method according to claim 6, **characterized in that** the transmission powers (P_{S}) and/or the phases of the RF signals are adjusted for the duration of a pulse sequence, wherein, during the pulse sequence, several measurements of the radio frequency H or E field respectively generated by the RF coil are carried out.

8. Method according to claim 6, **characterized in that** the transmission powers (P_{S}) and/or the phases of the RF signals are adjusted for the duration of one single pulse, wherein the radio frequency H or E field respectively generated by the RF coil is measured in dependence on time.

9. Method according to claim 8, **characterized in that** the regulation of the transmission power (P_{S}) is performed for the duration of one pulse such that the RF pulse shape generated thereby coincides with a previously determined pulse shape.

10. Nuclear magnetic resonance (NMR) system for performing a method according to any one of the claims 6 though 9, comprising
- a spectrometer with a transmitter which is designed to transmit RF signals at measuring frequencies with a transmission power (P_{S}),
- an NMR probe head with at least one RF oscillating circuit which is tuned by means of first RF components (BE) to the resonance frequency of a type of nucleus to be investigated,
wherein the RF oscillating circuit comprises an RF coil (L_{E}) which is disposed around a measuring sample and, by emitting RF signals, is used to excite nuclear spins in the sample and receive NMR signals resulting from this excitation,
wherein the probe head may contain further RF components (B_{K}) which may be components of RF oscillating circuits, of the coupling and filter networks, and
- exactly one measuring probe which is designed to measure the radio frequency H field generated by the RF coil, via which H field the current in or the voltage over the RF coil (L_{E}) or the first RF components (B_{E}) or further RF components (B_{K}) can be determined, wherein the probe is inductively coupled to the RF coil (L_{E}), and
- a control loop for controlling and limiting the transmission power (P_{S}) in dependence on the measured field, wherein the control loop is designed to increase the transmission power (Ps) up to maximum permissible current and/or voltage values in/over the RF coil (L_{E}) or at least one of the first RF components (BE) or, as the case may be, one of the further RF components (B_{K}), at which values the RF coil (L_{E}) or the first RF component (BE) or the further RF component (BE, L_{E}, B_{K}) are just not destroyed.

## Revendications

1. Procédé de régulation de signaux haute fréquence (HF) dans un système de résonance magnétique nucléaire (RMN) comprenant un spectromètre, une boucle de régulation et une tête de mesure RMN,
- le spectromètre comprenant un émetteur qui envoie des signaux HF sur des fréquences de mesure avec une puissance d'émission (P_{S}),
- la tête de mesure RMN contenant au moins un circuit oscillant HF qui est accordé au moyen de premiers composants HF (B_{E}) sur la fréquence de résonance d'un type de noyau à analyser,
- le circuit oscillant HF comprenant au moins une bobine HF (LE) qui est disposée autour d'un échantillon de mesure et qui sert, par envoi des signaux HF, à exciter des spins nucléaires dans un échantillon et à recevoir des signaux de RMN résultant de cette excitation, et
- la tête de mesure RMN pouvant contenir d'autres composants HF (B_{K}) qui peuvent faire partie du circuit oscillant HF, de réseaux de couplage ainsi que de filtrage,
une mesure d'un paramètre étant effectuée à l'aide de la tête de mesure RMN, par laquelle le courant dans ou la tension aux bornes de la bobine HF (L_{E}) ou d'un des premiers composants HF (B_{E}) ou le cas échéant d'un des autres composants HF (B_{K}) peut être déterminé(e),
la boucle de régulation régulant et limitant la puissance d'émission (P_{S}) en fonction du paramètre mesuré,
**caractérisé en ce**
**que** des valeurs de courant et/ou de tension maximales autorisées dans/aux bornes de la bobine HF (L_{E}) ou d'un des premiers composants HF (B_{E}) ou le cas échéant d'un des autres composants HF (B_{K}) sont définies, qui n'entraînent pas encore la destruction de la bobine HF (L_{E}), du premier composant HF (B_{E}) ou de l'autre composant HF (B_{E}, L_{E}, B_{K}), la boucle de régulation augmentant la puissance d'émission (P_{S}) aussi longtemps que les valeurs de courant et/ou de tension maximales autorisées ne sont pas dépassées.

2. Procédé selon la revendication 1, **caractérisé en ce que** l'on mesure comme paramètre(s) la qualité du circuit oscillant HF et/ou l'adaptation d'impédance du circuit oscillant HF à une ligne de transmission.

3. Procédé selon la revendication 1, **caractérisé en ce que** l'on mesure comme paramètre la durée d'impulsion d'une impulsion HF d'un angle d'impulsion souhaité.

4. Procédé selon la revendication 3, **caractérisé en ce que** la durée d'impulsion est déterminée par détection d'au moins un signal de RMN au moyen du spectromètre RMN.

5. Procédé selon la revendication 4, **caractérisé en ce qu'**une valeur de départ (P_{S0}), de préférence la puissance d'émission maximale (Pₘₐₓ), est choisie pour la puissance d'émission (P_{S}), que le signal de RMN est reçu au moyen du spectromètre RMN, une impulsion HF avec la valeur de départ (P_{S0}) de la puissance d'émission étant émise ; que l'angle d'impulsion de l'impulsion HF émise pour générer le signal de RMN est déterminé au moyen du signal de RMN reçu,
et que la puissance d'émission P_{S} de l'impulsion HF d'un angle d'impulsion souhaité et d'une durée d'impulsion souhaitée est déterminée par cet angle d'impulsion déterminé.

6. Procédé selon la revendication 1, **caractérisé en ce que** l'on mesure comme paramètre le champ H ou E à haute fréquence généré par la bobine HF.

7. Procédé selon la revendication 6, **caractérisé en ce que** les puissances d'émission (P_{S}) et/ou les phases des signaux HF sont adaptées sur la durée d'une suite d'impulsions, plusieurs mesures du champ H ou E à haute fréquence généré par la bobine HF étant effectuées pendant la suite d'impulsions.

8. Procédé selon la revendication 6, **caractérisé en ce que** les puissances d'émission (P_{S}) et/ou les phases des signaux HF sont adaptées sur la durée d'une seule impulsion, le champ H ou E à haute fréquence généré par la bobine HF étant mesuré en fonction du temps.

9. Procédé selon la revendication 8, **caractérisé en ce que** la régulation de la puissance d'émission (P_{S}) est réalisée sur la durée d'une impulsion de façon que la forme de l'impulsion HF ainsi générée concorde avec une forme d'impulsion préalablement définie.

10. Système de résonance magnétique nucléaire (RMN) pour réaliser un procédé selon une des revendications 6 à 9, comprenant :
- un spectromètre avec un émetteur conçu pour envoyer des signaux HF sur des fréquences de mesure avec une puissance d'émission (P_{S}),
- une tête de mesure RMN avec au moins un circuit oscillant HF qui est accordé au moyen de premiers composants HF (B_{E}) sur la fréquence de résonance d'un type de noyau à analyser,
le circuit oscillant HF comprenant une bobine HF (L_{E}) qui est disposée autour d'un échantillon de mesure et qui sert, par envoi des signaux HF, à exciter des spins nucléaires dans l'échantillon et à recevoir des signaux de RMN résultant de cette excitation,
la tête de mesure RMN pouvant contenir d'autres composants HF (B_{K}) qui peuvent faire partie de circuits oscillants HF, de réseaux de couplage ainsi que de filtrage, et
- exactement une sonde de mesure qui est conçue pour mesurer le champ HF à haute fréquence qui est généré par la bobine HF, au moyen duquel le courant dans ou la tension aux bornes de la bobine HF (L_{E}) ou des premiers composants HF (B_{E}) ou d'autres composants HF (B_{K}) peut être déterminé(e), la sonde étant couplée par induction à la bobine HF (LE), et
- une boucle de régulation pour réguler et limiter la puissance d'émission (P_{S}) en fonction du champ mesuré, la boucle de régulation étant conçue pour augmenter la puissance d'émission (P_{S}) aussi longtemps que les valeurs de courant et/ou de tension maximales autorisées dans/aux bornes de la bobine HF (L_{E}) ou d'au moins un des premiers composants HF (B_{E}) ou le cas échéant d'un des autres composants HF (B_{K}), qui n'entraînent pas encore la destruction de la bobine HF (LE), du premier composant HF (B_{E}) ou de l'autre composant HF (B_{E}, L_{E}, B_{K}), ne sont pas dépassées.
